# EUROPEAN PATENT SPECIFICATION

(11) **EP 3 241 005 B1**
(45) Date of publication and mention of the grant of the patent: **13.03.2019**
(21) Application number: 14837013.3
(22) Date of filing: 31.12.2014
(51) Int. Cl.: G01K 11/26, H03H 3/04, H03H 9/24

(54) **MEMS TEMPERATURE SENSOR**
MEMS-TEMPERATURFÜHLER
CAPTEUR DE TEMPÉRATURE MEMS

(43) Date of publication of application: 08.11.2017
(73) Proprietor: Azgin, Kivanc, 06800 Cankaya/Ankara (TR)
(72) Inventor: KOSE, Talha, Toronto/ON, M4Y 1K7 (CA)
(74) Representative: Inal, Aysegul Seda
(86) International application number: PCT/TR2014/000532
(87) International publication number: WO 2016/108771

(56) References cited:
- WO-A2-2014/037695
- JP-A- 2008 177 723
- US-A1- 2007 228 891
- AZEVEDO R G ET AL: "Dual-mode temperature compensation for a comb-driven MEMS resonant strain gauge", SENSORS AND ACTUATORS A, ELSEVIER SEQUOIA S.A., LAUSANNE, CH, vol. 144, no. 2, 15 June 2008 (2008-06-15) , pages 374-380, XP022664318, ISSN: 0924-4247, DOI: 10.1016/J.SNA.2008.02.007 [retrieved on 2008-02-23]

## Description

### Related Field of the Invention

The invention relates to resonant MEMS temperature sensors that sense the temperature changes by monitoring the frequency shifts of more than one DETF resonators resulting from the changing temperature.

### Background of the Invention (Prior Art)

A resonator is a device or system that exhibits resonance or resonant behavior, that is, it naturally oscillates at some frequencies, called its resonant frequencies, with greater amplitude than at others.

The dual beam resonator design, often referred to as double ended tuning fork (DETF) resonator utilizes two coupled beams vibrating out-of-phase or in-phase. The dynamic motion causes the shear and moment reactions at the end of the beams to cancel. The stresses approach zero within the distance of a few beam widths from the root of the beam. With the use of this feature, bulky end isolation elements are not required. The resonators are small, simple and relatively easy to manufacture.

The basic layout of a DETF consists of two parallel, straight tines anchored to each other and the substrate at each end. Resonance is detected by measuring the change in capacitance between each tine and electrode as they vibrate.

Micromachined resonators show much promise as sensing elements within MEMS devices. With the developments over past years in micromachining technology, MEMS devices can be produced in large amounts with low cost, which leads to an increase in the use of MEMS devices in various applications. That increasing use of MEMS devices comes up with the necessity to better performances of MEMS devices.

Due to their small sizes, MEMS devices can be affected by small environmental changes, which results in performance degradation of MEMS devices. Temperature change is one of the major effects that deteriorates the performance of MEMS devices. Hence, even small temperature changes should be monitored precisely for better performance characteristics of MEMS devices. Additionally, detection of temperature changes with high precision and sensitivity is an issue for many applications such as biomedical applications or military applications.

Detecting the temperature changes affecting the micro-scale devices via normal-scale temperature sensors or via an external temperature sensor placed outside of the MEMS device is not giving precise results. Also, sudden temperature changes cannot be sensed by those devices due to thermal lag issues. Hence, MEMS temperature sensors are in need to detect the temperature changes affecting the MEMS devices or to obtain the temperature information with high sensitivity.

Previous studies related with MEMS temperature sensors use complicated electronic circuits from which the temperature effects can be obtained, and performance of the MEMS device is corrected via the electronic circuit. Since the electronic components used in those electronic circuits also have temperature dependent performances, the temperature sensitivity of the circuit is limited by the temperature sensitivity of the electronic components, which is a major disadvantage.

Some other studies aim to overcome the temperature dependent performance characteristics of MEMS sensors by supplying a stabilized temperature environment for the MEMS device. Micro-ovens are utilized for this purpose. The complexity of the fabrication steps and power consumption issues may be the reason for searching the alternative solutions for the temperature dependent performance degradation problem.

US2007/0228891 discloses a piezoelectric device comprising a double ended tuning fork.

### Brief Description of the Invention:

In this patent, it was aimed to sense the temperature changes in a sensitive way by monitoring the frequency shifts of two or more DETF resonators resulting from the changing temperature. At least one of the DETF resonators existing in the proposed temperature sensor design is utilized as a frequency base for the frequency counter, which is also affected by the temperature changes in a same way but with a different amount than the other DETF resonator. This difference is achieved by arranging the sizes of the DETF structures. By this way, the need for a high stability base for the frequency counter is eliminated, which is critical in terms of simplifying the electronic read-out circuit of the sensor while preserving the precision.

With the help of additional compressive beam presented in temperature sensor design, the sensitivity to the temperature change enhanced so that even smaller changes in temperature can be sensed.

By integrating the temperature sensor offered in this patent next to any other MEMS sensor i.e. inertial MEMS sensor, labs-on-chip, etc., the temperature changes affecting the performances of MEMS sensors can be compensated by using the temperature change information obtained via the MEMS resonator. This on-chip integration may be achieved by creating common anchor regions between the resonator and the other MEMS sensor so that the temperature change affects both sensors with almost same amount. That gives the advantage of low thermal time constant for the temperature sensor and results with ability to sense the temperature changes precisely and quickly.

### Definition of the Figures

In order to explain the present invention in more detail, the following figures have been prepared and attached to the description. The list and the definition of the figures are given below.
**FIGURE 1** top view of mems temperature sensor structure
**FIGURE 2** perspective view of mems temperature sensor structure
**FIGURE 3** top view of alternative mems temperature sensor structure
**FIGURE 4** perspective view of alternative mems temperature sensor structure
**FIGURE 5** perspective view of the integration of the MEMS temperature sensor next to a capacitive MEMS inertial sensor

### Definition of the Elements (Features/Components/Parts) on the Figures

The definition of the features/components/parts that are covered in the figures that are prepared in order to explain the present invention better are separately numbered and given below.
1. Long DETF resonator
2. Short DETF resonator
3. Compressive beam
4. Electrode set 1 for short DETF resonator
5. Electrode set 2 for short DETF resonator
6. Electrode set 1 for long DETF resonator
7. Electrode set 2 for long DETF resonator
8. Anchor region for short DETF resonator
9. Anchor region for long DETF resonator
10. Anchor region for compressive beam
11. Tines of long DETF resonator
12. Tines of short DETF resonator
13. Connector beam between tines of long DETF
14. Connector beam between tines of short DETF
15. Additional capacitive plate connected to tines of long DETF resonator
16. Additional capacitive plate connected to tines of short DETF resonator
17. Illustration of capacitive MEMS inertial sensor
18. Common Anchor Region

### Detailed Description of The Invention

The present invention. aims to sense the temperature changes in a sensitive way by monitoring the frequency shifts of two DETF resonators (1, 2) resulting from the changing temperature.

MEMS temperature sensor mentioned in this patent application consists of three fundamental components: two or more double-ended-tuning-fork (DETF) resonators (1, 2) placed next to each other and an additional compressive beam (3) attached to the resonators at one end. Two DETF resonators (1, 2) differ from each other with their sizes which will be designated as long DETF resonator (1) and short DETF resonator (2).

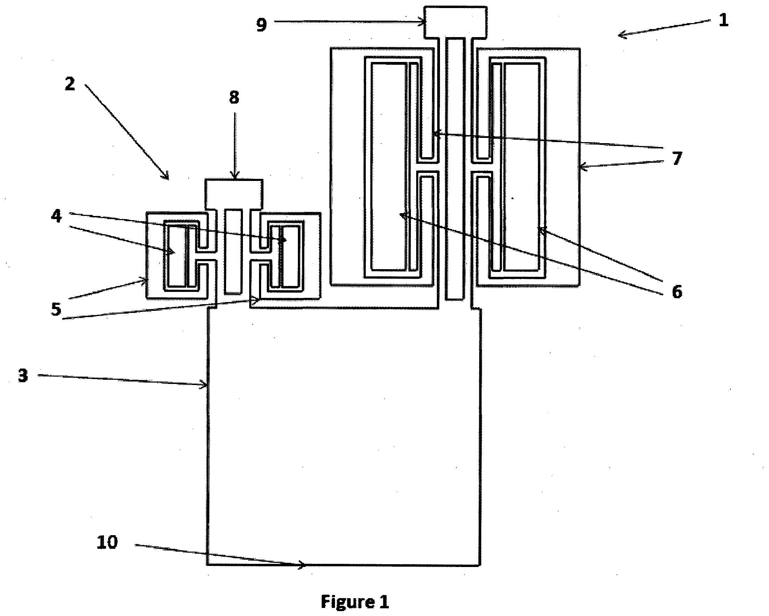

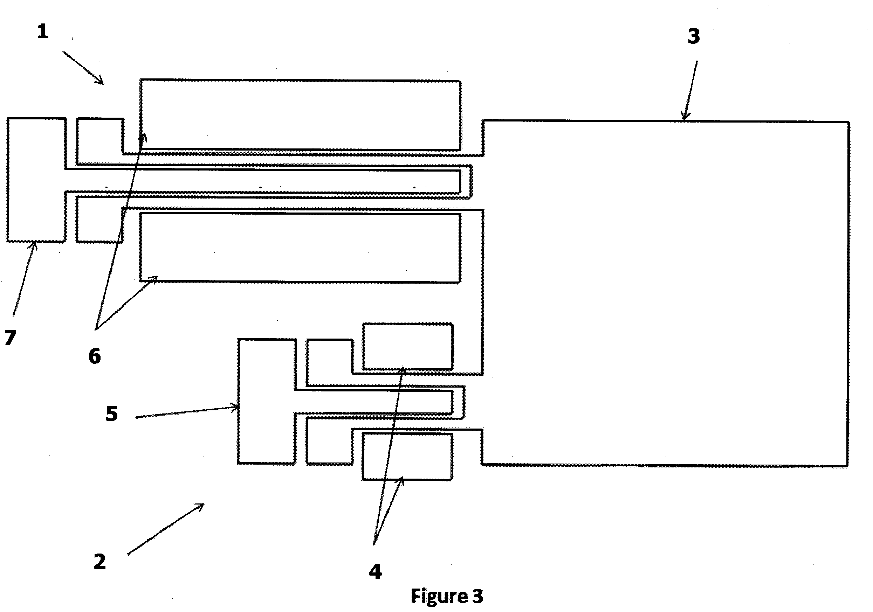

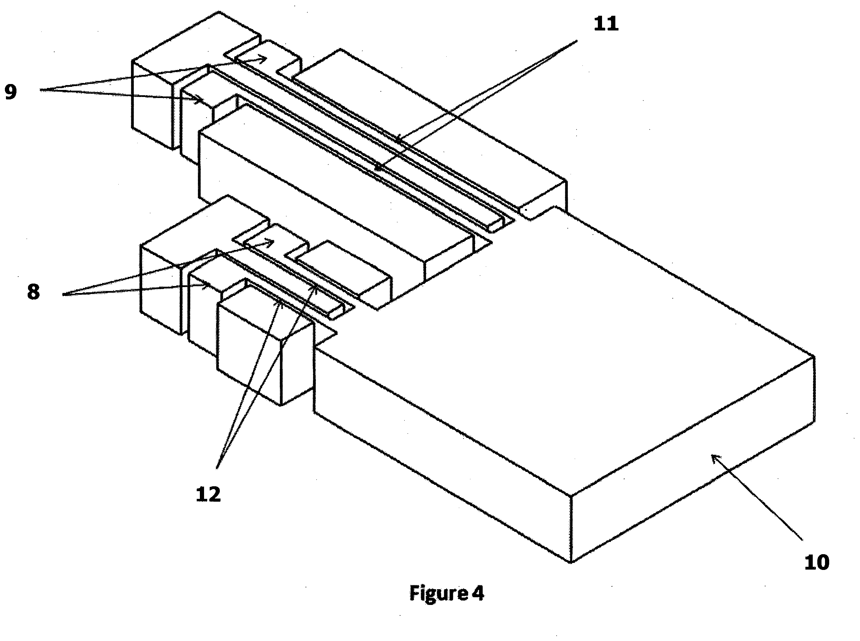

Each DETF resonator (1, 2) consists of three main components: a drive electrode, a sense electrode and tines of DETF structure (11, 12). Drive electrode and sense electrode may be composed of two or more parts as illustrated in figure 1, 2, 3 and 4 provided that those parts are electrically connected to each other such as using metal lines etc.

Besides the shape and size of electrodes, (5, 7) may also be varied depending on the application. The electrode sets (4, 5, 6, 7) designated as drive electrodes can also be utilized as sense electrodes in the case that sense electrode sets (4, 5, 6, 7) are used as drive electrodes. Tines of DETF structures (11, 12) are the parts which are able to move i.e. in resonance induced by capacitive actuation methods. Tines of DETF structures are connected to anchors (8, 9) at one end where the resonators are fixed to the substrate. Other end of the tines are connected to the compressive beam (3) which is also suspended i.e. able to move.

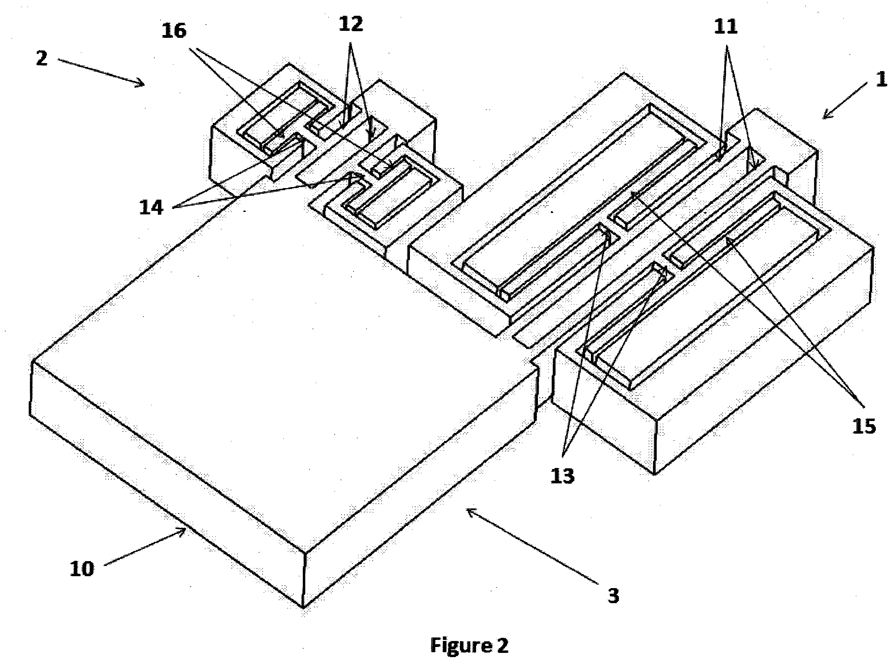

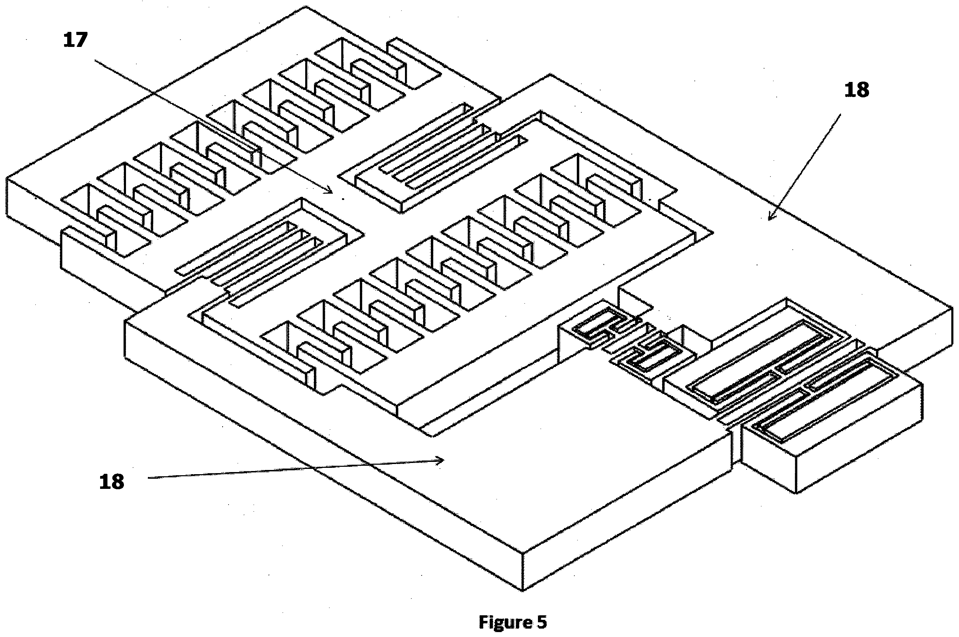

The compressive beam (3) is fixed at the other end with the anchor regions (10) to the substrate. The tines of DETF structures may also be varied with additional components such as illustrated in Figure 1 and 2 i.e. a capacitive plate (15, 16) is added to the tines of the DETF by means of a connector beam (13, 14). In Figure 5, the common anchor regions (18) illustrate with parts which integrates the anchors of temperature sensor with MEMS inertial sensor (17) on the same chip.

Structures expand or contract with the changes in thermal conditions due to the material nature (thermal expansion and material constant variations at different temperatures). The contraction and expansion behavior of the materials is defined by their thermal expansion coefficients. MEMS temperature sensor offered in this patent application is based on the resonance frequency change under changing temperature by taking advantage of the phenomenon observed in the material nature.

Under changing temperature, the tines of the DETF (11, 12) resonators have a tendency to expand or to contract depending on the change in temperature and thermal expansion coefficients of the material of DETF resonators and the substrate on which the resonators are fixed, which causes an axial force on the tines of DETF. That axial force on the tines of DETF resonator structure causes a change in stiffness of the tines of DETF resonators (1, 2) which leads to the resonance frequency shifts for some certain modes.

Since one end of tines is fixed by the anchor region (8, 9) the tines tend to expand or to contract at the other end where the compressive beam is attached to the tines. With the same temperature change, the compressive beam (3) which is also fixed at one end via anchor region (10) and connected to the tines at the other end, have a tendency to expand or to contract towards the tines of the resonators (1, 2). These expansions (or contractions) of the tines of DETF resonators (1, 2) and the compressive beam (3) are added to each other since both of which are fixed at one end.

That leads to an increase in the magnitude of the axial force on the tines, which results with the increased sensitivity of the temperature sensors. It should be noted that in order to have a contraction or expansion, which leads to an axial force on the tines of the DETF resonators (1,2), the sensor structures and substrate on which the sensor sits should have different thermal expansion coefficients, i.e. sensor material may be single crystal silicon, and the substrate may be glass (SiO₂). Since the sensitivity of the temperature sensor depends on the difference in thermal expansion coefficients between the substrate and the sensor material, the sensitivity can be configured by changing the material of the substrate or sensor structure depending on the application. The resonance frequencies of the DETF resonators (1, 2) can be monitored by the help of a self-oscillation loop or phase-locked-loop. One of the DETF resonators (1, 2) is utilized as a frequency base for the counter that counts the frequency of the other DETF resonator (1, 2).

MEMS temperature sensor structures can easily be adapted to many other MEMS sensors since the fabrication of MEMS temperature sensors is not complicated (Figure 5). When the MEMS temperature sensor is placed next to any other MEMS sensor with common anchor regions (18) the temperature change affecting the MEMS sensor is directly and properly sensed by MEMS temperature sensor offered in this patent application. This integration results in low thermal time constants, which means fast responses to the change of temperature. Hence, by this way, the temperature changes could be detected truly and quickly so that the performance deteriorations of the MEMS sensor due to changing temperature can be compensated.

The implementation of the MEMS temperature sensor, by using at least two temperature resonators (1, 2), temperature changes can be precisely and quickly detected, system performance degradation based on that the temperature changes are corrected.

According to known systems, the present invention has ease of integration being on the same scales with integrated sensor system, which can detect the temperature change properly. In addition, the length of the resonator structure can be tuned so that the resonators can be operated in the desired dynamic range.

## Claims

1. MEMS temperature sensor comprising two or more double-ended-tuning-fork (DETF) resonators (1, 2) placed next to each other and an additional compressive beam (3) attached to the resonators (1,2) at one end, **characterized in that** two or more DETF resonators (1, 2) differ from each other with their sizes which will be designated as long DETF resonator (1) and short DETF resonator (2).

2. MEMS temperature sensor according to claim 1; wherein each DETF resonator (1, 2) consists of three main components: a drive electrode, a sense electrode and tines of DETF structure (11, 12).

3. MEMS temperature sensor according to claim 1; wherein under changing temperature, the tines of the DETF (11, 12) resonators expand or contract depending on the change in temperature and thermal expansion coefficients of the material of DETF resonators (1, 2) and the substrate on which the resonators are fixed, which causes an axial force on the tines of DETF and that axial force on the tines of DETF resonator (1, 2) structure causes a change in stiffness of the tines of DETF resonators (1, 2) which leads to resonance frequency shifts.

4. MEMS temperature sensor according to claim 1; wherein under changing temperature, the materials the tines of the DETF (11, 12) are made of have a temperature dependent elastic modulus, which, in case of a temperature change, cause a change in stiffness of the tines of DETF resonators (1, 2) which leads to resonance frequency shifts.

5. MEMS temperature sensor according to claim 1; wherein under changing temperature, the materials the tines of the DETF (11, 12) are made of have a temperature dependent expansion coefficient, which, in case of a temperature change, cause a change in dimensions of the tines and capacitive structures of DETF resonators (1, 2) which leads to resonance frequency shifts.

6. MEMS temperature sensors according to claim 1 or 4; wherein one end of tines is fixed by an anchor region (8, 9), the tines expand or contract at the other end where the compressive beam (3) is attached to the tines with the same temperature change, the compressive beam (3) which is also fixed at one end to another anchor region (10) and connected to the tines at the other end, expands or contracts towards the tines of the resonators (1, 2).

7. MEMS temperature sensors according to claim 1; wherein the resonance frequencies of the DETF resonators (1, 2) can be monitored by the help of a self-oscillation loop or phase locked loop and at least one of the DETF resonators (1, 2) is utilized as a frequency base for a counter that counts the frequency of the other DETF resonator (1, 2).

8. MEMS temperature sensor according to claims 1 or 5; wherein during the fabrication of this temperature sensor, the material of DETF resonators (1, 2) and additional compressive beam (3) and the material of the substrate on which the DETF resonators (1, 2) and additional compressive beam (3) are fixed, can be selected as any material provided that the temperature sensor material and the substrate material have different thermal expansion coefficients.

## Patentansprüche

1. MEMS Temperatursensor, umfassend zwei oder mehr Resonatoren (1, 2) mit doppelseitiger Abstimmung (DETF), die nebeneinander platziert sind, und einen zusätzlichen Druckstrahl (3), der an einem Ende an den Resonatoren (1, 2) befestigt ist, **dadurch gekennzeichnet, dass** sich zwei oder mehr DETF Resonatoren (1, 2) in ihren Größen voneinander unterscheiden, die als langer DETF Resonator (1) und kurzer DETF Resonator (2) bezeichnet werden.

2. MEMS Temperatursensor nach Anspruch 1; wobei jeder DETF Resonator (1, 2) aus drei Hauptkomponenten besteht: einer Antriebselektrode, einer Senselektrode und Zinken der DETF Struktur (11, 12).

3. MEMS Temperatursensor nach Anspruch 1; wobei sich die Zinken der DETF (11, 12) Resonatoren bei ändernder Temperatur in Abhängigkeit von der Änderung der Temperatur und Wärmeausdehnungskoeffizienten des Materials der DETF Resonatoren (1, 2) und des Substrats, auf dem die Resonatoren fixiert sind, die eine Axialkraft auf die Zinken von DETF und diese Axialkraft auf die Zinken von DETF Resonator (1, 2) Struktur eine Änderung der Steifigkeit der Zinken von DETF Resonatoren (1, 2) bewirkt, was zu Resonanzfrequenzverschiebungen führt.

4. MEMS Temperatursensor nach Anspruch 1; wobei unter Änderung der Temperatur die Materialien, aus denen die Zinken des DETF (11, 12) bestehen, einen temperaturabhängigen Elastizitätsmodul aufweisen, der bei einer Temperaturänderung eine Änderung der Steifigkeit der Zinken von DETF Resonatoren (1, 2) bewirkt, die zu Resonanzfrequenzverschiebungen führt.

5. MEMS Temperatursensor nach Anspruch 1; wobei unter Änderung der Temperatur die Materialien, aus denen die Zinken des DETF (11, 12) bestehen, einen temperaturabhängigen Ausdehnungskoeffizienten aufweisen, der im Falle einer Temperaturänderung eine Änderung der Zinken und kapazitiven Strukturen von DETF Resonatoren (1, 2) bewirkt, die zu Resonanzfrequenzverschiebungen führt.

6. MEMS Temperatursensoren nach Anspruch 1 oder 4; wobei ein Ende der Zinken durch einen Ankerbereich (8, 9) fixiert ist, sich die Zinken am anderen Ende ausdehnen oder zusammenziehen, worin der Druckstrahl (3) mit der gleichen Temperaturänderung an den Zinken befestigt ist, der Druckstrahl (3), der ebenfalls an einem Ende an einem anderen Ankerbereich (10) fixiert ist und mit den Zinken am anderen Ende verbunden ist, sich zu den Zinken der Resonatoren (1, 2) ausdehnt oder zusammenzieht.

7. MEMS Temperatursensoren nach Anspruch 1; wobei die Resonanzfrequenzen der DETF Resonatoren (1, 2) mit Hilfe eines Selbstoszillationskreises oder Phasenregelkreises überwacht werden können und mindestens einer der DETF Resonatoren (1, 2) als Frequenzbasis für einen Zähler verwendet wird, der die Frequenz des anderen DETF Resonators (1, 2) zählt.

8. MEMS Temperatursensor nach Anspruch 1 oder 5; wobei während der Herstellung dieses Temperatursensors das Material von DETF Resonatoren (1, 2) und zusätzlichem Druckstrahl (3) und das Material des Substrats, auf dem die DETF Resonatoren (1, 2) und der zusätzliche Druckstrahl (3) fixiert sind, als jedes Material ausgewählt werden kann, vorausgesetzt, dass das Temperatursensormaterial und das Substratmaterial unterschiedliche thermische Ausdehnungskoeffizienten aufweisen.

## Revendications

1. Capteur de température MEMS comprenant deux ou plusieurs résonateurs (1, 2) de type diapasons à deux extrémités (DETF) placés l'un à côté de l'autre et un faisceau de compression supplémentaire (3) fixé aux résonateurs (1, 2) à une extrémité, **caractérisé en ce que** deux ou plusieurs résonateurs DETF (1, 2) diffèrent l'un de l'autre avec leurs tailles qui seront désignées comme résonateur DETF longue (1) et résonateur DETF court (2).

2. Capteur de température MEMS selon la revendication 1 ; dans lequel chaque résonateur DETF (1, 2) est constitué de trois composants principaux : une électrode de commande, une électrode de détection et des dents de structure DETF (11, 12).

3. Capteur de température MEMS selon la revendication 1 ; dans lequel sous l'effet du changement de température, les dents des résonateurs DETF (11, 12) se dilatent ou se contractent en fonction de la variation des coefficients de température et de dilatation thermique du matériau des résonateurs DETF (1, 2) et le substrat sur lequel sont fixés les résonateurs qui provoque une force axiale sur les dents du DETF et cette force axiale sur les dents de la structure de résonateur DETF (1, 2) provoque une modification de la rigidité des dents des résonateurs DETF (1, 2) qui entraîne une fréquence de résonance shifts

4. Capteur de température MEMS selon la revendication 1 ; dans lequel sous l'effet du changement de température, les matériaux dont sont faites les dents du DETF (11, 12) ont un module élastique dépendant de la température, qui, en cas de changement de température, provoque une modification de la rigidité des dents des résonateurs DETF (1, 2) qui entraîne des décalages de fréquence de résonance.

5. Capteur de température MEMS selon la revendication 1 ; dans lequel sous l'effet du changement de température, les matériaux dont sont faites les dents du DETF (11, 12) ont un module élastique dépendant du coefficient de dilatation, qui, en cas de changement de température, provoque une modification des dimensions des dents et des structures capacitives des résonateurs DETF (1, 2) qui entraîne des décalages de fréquence de résonance.

6. Capteurs de température MEMS selon la revendication 1 ou 4 ; dans lequel une extrémité des dents est fixée par une région d'ancrage (8, 9), les dents se dilatent ou se contractent à l'autre extrémité où le faisceau de compression (3) est fixée aux dents avec le même changement de température, le faisceau de compression (3) qui est également fixée à une extrémité à une autre zone d'ancrage (10) et reliée aux dents à l'autre extrémité, se dilate ou se contracte vers les dents des résonateurs (1, 2).

7. Capteurs de température MEMS selon la revendication 1 ; dans lequel les fréquences de résonance des résonateurs DETF (1, 2) peuvent être surveillées à l'aide d'une boucle à auto-oscillation ou à verrouillage de phase et au moins un des résonateurs DETF (1, 2) est utilisé comme base de fréquence pour un compteur qui compte la fréquence de l'autre résonateur DETF (1, 2).

8. Capteurs de température MEMS selon les revendications 1 ou 5 ; dans lequel pendant la fabrication de ce capteur de température, le matériau des résonateurs DETF (1, 2) et du faisceau de compression supplémentaire (3) et le matériau du substrat sur lequel les résonateurs DETF (1, 2) et le faisceau de compression supplémentaire (3) sont fixés, peuvent être choisis comme n'importe quel matériau à condition que le matériau du capteur de température et le matériau du substrat aient des coefficients de dilatation thermique différents.
